# EUROPÄISCHE PATENTSCHRIFT

(11) **EP 0 534 161 B1**
(45) Veröffentlichungstag und Bekanntmachung des Hinweises auf die Patenterteilung: **08.11.1995**
(21) Anmeldenummer: 92114660.1
(22) Anmeldetag: 27.08.1992
(51) Int. Cl.: H05K 3/34, B23K 1/00

(54) **Lötsystem zum Auflöten von oberflächenbefestigbaren Bauteilen auf Leiterplatten**
Solder system for soldering surface-mountable components on circuit boards
Système de brasage pour braser des composants montables en surface sur cartes à circuits imprimés

(30) Priorität: 25.09.1991 DE 9111967 U
(43) Veröffentlichungstag der Anmeldung: 31.03.1993
(73) Patentinhaber: Siemens Nixdorf Informationssysteme Aktiengesellschaft, 33102 Paderborn (DE)
(72) Erfinder: Thorwarth, Rüdiger, W-8019 Glonn (DE); Scholz, Leo, W-8025 Unterhaching (DE)
(74) Vertreter: Fuchs, Franz-Josef, Dr.-Ing.

(56) Entgegenhaltungen:
- EP-A- 0 130 643
- EP-A- 0 378 113
- WO-A-91/12920
- US-A- 4 894 506

## Beschreibung

Die Erfindung betrifft ein Lötsystem zum Auflöten von oberflächenbefestigbaren Bauteilen auf Leiterplatten gemäß dem Oberbegriff des Patentanspruches 1.

Die Montage von oberflächenbefestigbaren Bauteilen auf Leiterplatten erfolgt bekanntlich in der Weise, daß die Bauteile zu vorgegebenen Einbauplätzen der Leiterplatte justiert und anschließend aufgelötet werden. Bei der Justierung des Bauteils werden dessen Anschlußkontakte zu den auf der Leiterplatte angeordneten Lötflecken (Pads) lagerichtig plaziert. Die Leiterplatten sind, bedingt durch den Herstellungsprozeß, wellig und weisen Dickentoleranzen auf. Außerdem ist die durch verschiedene Verfahren aufgebrachte und umgeschmolzene Lotauflage unterschiedlich dick. Dies führt zu einer ungleichmäßigen Kontur auf der Oberfläche der Leiterplatte.

Für den Lötvorgang werden je nach Anwendung ein oder mehrere temperaturgeregelte Lötbügel verwendet, deren Kontaktfläche jeweils mittels von außen zugeführtem Strom erwärmt werden kann. Bei herkömmlichen Lötsystemen ist der Lötbügel an einem Lötbügelhalter starr befestigt, der durch ein Hubsystem vertikal in Richtung der Leiterplatte absenkbar und wieder anhebbar ist. Beim Absenken des fest montierten Lötbügels kommt dessen Kontaktfläche auf dem höchsten Pad der Leiterplattenkontur zu liegen, wobei die für die Wärmeankontaktierung der einzelnen Anschlußkontakte erforderliche Kraft mechanisch durch Druckfedern erzeugt wird.

Da der höchste Punkt normalerweise nicht in der Mitte der Padreihe liegt, kommt es zu Schubkräften auf die Anschlußkontakte des Bauteils. Die Schubkräfte führen in der Schmelzphase des Lotes zu einer Dejustierung. Darüber hinaus entsteht durch die einseitige mechanische Kontaktierung ein ungleichmäßiger Wärmefluß über die Anschlußkontakte des Bauteils zur Leiterplatte. Dies kann gegebenenfalls zu einer thermischen Überbelastung einzelner Pads führen.

Aus der US-Patentschrift 4 894 506 ist ein Lötsytem zum Auflöten von Bauteilen mit elektrischen Anschlußkontakten auf Leiterplatten bekannt, bei dem mindestens ein in einer Haltevorrichtung geführter Lötbügel eine Pendelbewegung in Abhängigkeit eines festen Drehpunkts aus führt. Bei einer derartigen kraftschlüssigen mechanischen Anordnung wird der Lötbügel über den Drehpunkt zwangsgeführt. Die drehpunktabhängige Pendelbewegung führt zu einer Selbstausrichtung des Lötbügels an den Anschlußkontakten.

Es ist Aufgabe der vorliegenden Erfindung, ein Lötsystem für oberflächenbefestigbare Bauteile auf Leiterplatten zu schaffen, durch das die Kontaktfläche eines Lötbügels in der Weise an der Leiterplattenkontur ausgerichtet wird, daß möglichst keine Schubkräfte auf die Anschlußkontakte des Bauteils entstehen.

Diese Aufgabe wird gemäß der Erfindung dadurch gelöst, daß der Lötbügel durch magnetische Kräfte in der Haltevorrichtung bezüglich der Lage seiner Kontaktfläche zur Oberfläche der Leiterplatte derart schwimmend gelagert ist, daß sich die Kontaktfläche des Lötbügels selbsttätig zur Oberfläche der Leiterplatte ausrichtet. Beim Absenken des Lötbügels erfolgt die Kontaktierung nur mit dem Eigengewicht des Bügels und der Haltevorrichtung. Es entstehen so gut wie keine Schubkräfte auf die Anschlußkontakte des Bauteils. Das gemäß der Erfindung ausgebildete Lötsystem gewährleistet eine gleichmäßige Lötqualität unabhängig von der Gestaltung der Leiterplattenkontur und ohne eine Zwangsführung des Lötbügels über einen festen Drehpunkt.

Gemäß der Erfindung weist die Haltevorrichtung ein festes Führungselement auf, in dem ein bewegliches Element mit dem daran angebrachten Lötbügel geführt ist. Die für die schwimmende Lagerung des Lötbügels in beiden Elementen vorgesehenen Mittel zur Erzeugung der magnetischen Kräfte bewirken eine Abstoßung des beweglichen Elements vom Führungselement. Gemäß einer bevorzugten Ausführungsform werden Ferritmagnete, die eine gegenseitige abstoßende Wirkung haben, eingesetzt, da diese kleine Abmessungen aufweisen und in ein Lötsystem der eingangs genannten Art einfach zu integrieren sind.

Gemäß einer Weiterbildung der Erfindung können die magnetischen Kräfte von elektrischen Spulen erzeugt werden, mit denen während des Lötvorgangs ein wiederholtes Anheben und Absenken des Lötbügels einfach zu steuern ist.

Die Erfindung wird anhand eines in der Zeichnung dargestellten Ausführungsbeispiels näher erläutert.

Im einzelnen zeigen
FIG 1 das erfindungsgemäße Lötsystem mit einer teilweise aufgebrochen dargestellten Haltevorrichtung für einen Lötbügel und
FIG 2 das Lötsystem in seitlicher Schnittansicht.

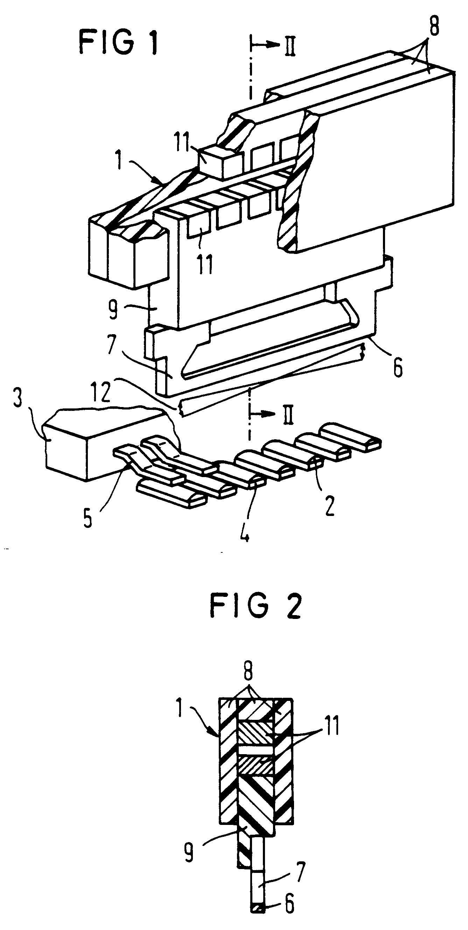

In FIG 1 ist ein Lötsystem 1 zum Auflöten eines oberflächenbefestigbaren Bauteils 3 auf eine Leiterplatte gezeichnet. Vor dem Lötvorgang erfolgt eine Justierung des Bauteils 3, bei der dessen Anschlußkontakte 5 zu den auf der Leiterplatte angeordneten Lötflecken 4 lagerichtig plaziert werden. Dadurch, daß die Zinnauflage 2 auf den Lötflecken 4 unterschiedlich dick sein kann, entsteht eine ungleichmäßige Kontur auf der Oberfläche der Leiterplatte.

Im Lötsystem 1 ist ein temperaturgeregelter Lötbügel 7 vorgesehen, dessen Kontaktfläche 6 durch von außen zugeführtem Strom erwärmt werden kann. Der Lötbügel 7 ist an einem beweglichen Element 9 angebracht, wobei die Befestigung durch eine lösbare Verbindung, beispielsweise eine Schraubverbindung, hergestellt werden kann. Gemeinsam mit einem festen Führungselement 8, beispielsweise bestehend aus drei lösbar miteinander verbundenen Teilelementen, bildet das bewegliche Element 9 eine Haltevorrichtung, in der der Lötbügel 7 geführt und bezüglich der Lage seiner Kontaktfläche 6 zur Leiterplattenoberfläche schwimmend gelagert ist.

Die schwimmende Lagerung des Lötbügels wird durch Ferritmagnete 11 erreicht, die einander gegenüberliegend im festen Führungselement 8 sowie im beweglichen Element 9 angeordnet sind. Die Ferritmagnete 11 liefern gegenseitige magnetische Kräfte, die eine Abstoßung des beweglichen Elements 9 vom festen Führungselement 8 bewirken. Auf diese Weise wird die Kontaktfläche 6 des Lötbügels 7 selbsttätig mit geringer Andruckkraft zur Leiterplattenkontur unter Vermeidung eines festen Drehpunkts ausgerichtet. Die mögliche Ausrichtung des Lötbügels 7 bei der Kontaktierung ist durch einen Bewegungsverlauf 12 angedeutet, der eine ausgleichende Pendelbewegung darstellt, die unabhängig von einem Drehpunkt erfolgt. Die Ferritmagnete 11 sind wegen ihrer kleinen Abmessungen einfach in die Haltevorrichtung einzubauen und entsprechend der Breite der Kontaktfläche 6 des Lötbügels 7 gleichmäßig verteilt in den beiden Elementen 8 und 9 anzuordnen.

Beim Absenken des Lötbügels 7 erfolgt die Kontaktierung nur mit dem Eigengewicht des Bügels und der Haltevorrichtung. Durch die grundsätzlich vom höchsten Punkt aus erfolgende selbsttätige Ausrichtung der Kontaktfläche 6 des Lötbügels 7 zur Oberfläche der Leiterplatte entstehen so gut wie keine Schubkräfte auf die Anschlußkontakte 5 des Bauteils 3. Auf diese Weise läßt sich eine gleichmäßige Lötqualität unabhängig von der Gestaltung der Leiterplattenkontur sowie unabhängig von einer Zwangsführung des Lötbügels 7 erzielen.

Die magnetischen Kräfte, die für die Abstoßung des beweglichen Elements 9 vom festen Führungselement 8 sorgen, können auch von elektrischen Spulen bereitgestellt werden. Die Verwendung von Spulen hat den Vorteil, daß während des Lötvorgangs ein Druckprogramm ausgeführt werden kann.

FIG 2 zeigt das erfindungsgemäße Lötsystem 1 in der Seitenansicht anhand eines Schnittes durch das Lötsystem gemäß FIG 1 entlang einer Schnittlinie II-II. Der an dem beweglichen Element 9 der Haltevorrichtung befestigte Lötbügel 7 ist in dem festen Führungselement 8 geführt und darin bezüglich der Lage seiner Kontaktfläche 6 zur Oberfläche der Leiterplatte durch Anordnung von Ferritmagneten 11, die zu einer Abstoßung des beweglichen Elements 9 führen, schwimmend gelagert. Das feste Führungselement 8 besteht dabei aus drei Teilelementen, die beispielsweise über eine Schraubverbindung lösbar miteinander verbunden sind. Dadurch können die im Führungselement 8 vorgesehenen Ferritmagnete 11 durch Ein- und Ausbau des die Ferritmagnete 11 tragenden Mittelelements leicht ausgetauscht werden. Eine Ausbildung des festen Führungselements 8 als ein einziges Element mit den darin angeordneten Ferritmagneten 11 ist ebenfalls möglich. Unabhängig von der Gestalt des Führungselements können die beiden die Haltevorrichtung bildenden Elemente 8 und 9 aus unterschiedlichen, nichtmagnetischen Materialien hergestellt werden.

## Patentansprüche

1. Lötsystem zum Auflöten von oberflächenbefestigbaren Bauteilen (3) auf Leiterplatten, mit mindestens einem in einer Haltevorrichtung (8,9) geführten temperaturgeregelten Lötbügel (7), dessen Kontaktfläche (6) auf die über den Lötflecken (4) der Leiterplatte liegenden Anschlußkontakte (5) des Bauteils (3) absenkbar und von ihnen wieder abhebbar ist, **dadurch gekennzeichnet,** daß der Lötbügel (7) an einem beweglichen Element (9) der Haltevorrichtung (8,9) befestigt ist, das in einem festen Führungselement (8) der Haltevorrichtung (8,9) geführt ist, und daß in beiden Elementen (8, 9) Mittel (11) zur Erzeugung magnetischer Kräfte vorgesehen sind, die eine Abstoßung des beweglichen Elements (9) vom Führungselement (8) in der Weise bewirken, daß der Lötbügel (7) durch die magnetischen Kräfte in der Haltevorrichtung (8, 9) bezüglich der Lage seiner Kontaktfläche (6) zur Oberfläche der Leiterplatte derart schwimmend gelagert ist, daß sich die Kontaktfläche (6) des Lötbügels (7) selbsttätig zur Oberfläche der Leiterplatte ausrichtet.

2. Lötsystem nach Anspruch 1, **dadurch gekennzeichnet,** daß die Mittel zur Erzeugung der magnetischen Kräfte aus Ferritmagneten (11) bestehen, die in den Elementen (8,9) jeweils einander gegenüberliegend angeordnet sind.

3. Lötsystem nach Anspruch 2, **dadurch gekennzeichnet,** daß die Ferritmagnete (11) der Breite der Kontaktfläche (6) des Lötbügels (7) entsprechend gleichmäßig verteilt in den Elementen (8,9) angeordnet sind.

4. Lötsystem nach Anspruch 1, **dadurch gekennzeichnet,** daß die Mittel zur Erzeugung der magnetischen Kräfte aus elektrischen Spulen bestehen.

## Claims

1. Soldering system for soldering surface mounted components (3) onto printed circuit boards, having at least one temperature-controlled soldering bit (7) which is guided in a holding device (8, 9) and whose contact surface (6) can be lowered onto the connecting contacts (5) of the component (3) which are located above the solder lands (4) on the printed circuit board, and can be lifted off them again, characterized in that the soldering bit (7) is attached to a moving element (9) of the holding device (8, 9), which moving element (9) is guided in a fixed guide element (8) of the holding device (8, 9), and in that means (11) for producing magnetic forces are provided in both elements (8, 9), which means (11) produce repulsion of the moving element (9) from the guide element (8) in such a manner that the soldering bit (7) is supported by the magnetic forces in a floating manner in the holding device (8, 9) in terms of the position of its contact surface (6) with respect to the surface of the printed circuit board, in such a manner that the contact surface (6) of the soldering bit (7) is automatically aligned with respect to the surface of the printed circuit board.

2. Soldering system according to Claim 1, characterized in that the means for producing the magnetic forces comprise ferrite magnets (11) which are arranged in each case opposite one another in the elements (8, 9).

3. Soldering system according to Claim 2, characterized in that the ferrite magnets (11) are arranged distributed uniformly in the elements (8, 9), corresponding to the width of the contact surface (6) of the soldering bit (7).

4. Soldering system according to Claim 1, characterized in that the means for producing the magnetic forces are composed of electrical coils.

## Revendications

1. Système de brasage pour fixer par brasage des composants (3) pouvant être fixés en surface, sur des plaquettes à circuits imprimés, comportant au moins un étrier de brasage (7), qui est guidé dans un dispositif de retenue (8,9), et dont la température est réglée et dont la surface de contact (6) peut être abaissée sur les contacts de raccordement (5) du composant (3), qui sont situés au-dessus des plages de brasage (4) de la plaquette à circuits imprimés et peut être à nouveau écartée de ces plages, caractérisé par le fait que l'étrier de brasage (7) est fixé à un élément mobile (9) du dispositif de retenue (8,9), qui est guidé dans un élément fixe de guidage (8) du dispositif de retenue (8,9) et que dans les deux éléments (8,9) sont prévus des moyens (11) servant à produire des forces magnétiques, qui provoquent une répulsion de l'élément de bobine (9) à partir de l'élément de guidage (8) de manière que l'étrier de brasage (7) est monté flottant en ce qui concerne la position de sa surface de contact (6) par rapport à la surface de la plaquette à circuits imprimés, sous l'effet des forces magnétiques, dans le dispositif de retenue (8,9) de telle sorte que la surface de contact (6) de l'étrier de brasage (7) est alignée automatiquement par rapport à la surface de la plaquette à circuits imprimés.

2. Système de brasage suivant la revendication 1, caractérisé par le fait que les moyens pour produire des forces magnétiques sont constitués par des aimants en ferrite (11), qui sont disposés réciproquement en vis-à-vis les uns des autres dans les éléments (8,9).

3. Système de brasage suivant la revendication 2, caractérisé par le fait que les aimants en ferrite (11) sont disposés en étant répartis de façon uniforme, conformément à la largeur de la surface de contact (6) de l'étrier de brasage (7), dans les éléments (8,9).

4. Système de brasage suivant la revendication 1, caractérisé par le fait que les moyens pour produire les forces magnétiques sont constitués par des bobines électriques.
